(19) **Europäisches Patentamt European Patent Office Office européen des brevets**

(11) **EP 2 769 230 B1**

(12) **FASCICULE DE BREVET EUROPEEN**

(45) Date de publication et mention de la délivrance du brevet:
**09.09.2015 Bulletin 2015/37**

(21) Numéro de dépôt: **12775483.6**

(22) Date de dépôt: **17.10.2012**

(51) Int Cl.:
***G01R 31/11*** *(2006.01)*

(86) Numéro de dépôt international:
**PCT/EP2012/070540**

(87) Numéro de publication internationale:
**WO 2013/057131 (25.04.2013 Gazette 2013/17)**

(54) **PROCEDE DE REFLECTOMETRIE POUR LA DETECTION DE DEFAUTS NON FRANCS DANS UN CABLE ELECTRIQUE ET SYSTEME METTANT EN OUVRE LE PROCEDE**

REFLEKTOMETRIEVERFAHREN ZUR ERKENNUNG VON LEICHTEN DEFEKTEN BEI EINEM ELEKTRISCHEN KABEL SOWIE SYSTEM ZUR DURCHFÜHRUNG DES VERFAHRENS

REFLECTOMETRY METHOD FOR DETECTING SOFT FAULTS IN AN ELECTRICAL CABLE, AND SYSTEM FOR IMPLEMENTING THE METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.10.2011 FR 1159481**

(43) Date de publication de la demande:
**27.08.2014 Bulletin 2014/35**

(73) Titulaire: **Commissariat à l'Énergie Atomique et aux Énergies Alternatives 75015 Paris (FR)**

(72) Inventeur: **FRANCHET, Maud F-91440 Bures-sur-Yvette (FR)**

(74) Mandataire: **Hammes, Pierre Marks & Clerk France Immeuble Visium 22, avenue Aristide Briand 94117 Arcueil Cedex (FR)**

(56) Documents cités:
- **MAUD FRANCHET ET AL: "The use of the Pseudo Wigner Ville Transform for detecting soft defects in electric cables", ADVANCED INTELLIGENT MECHATRONICS (AIM), 2011 IEEE/ASME INTERNATIONAL CONFERENCE ON, IEEE, 3 juillet 2011 (2011-07-03), pages 309-314, XP032053458, DOI: 10.1109/AIM.2011.6026992 ISBN: 978-1-4577-0838-1 cité dans la demande**
- **L. COHEN: "Time-frequency distributions-a review", PROCEEDINGS OF THE IEEE, vol. 77, no. 7, 1 juillet 1989 (1989-07-01), pages 941-981, XP055019868, ISSN: 0018-9219, DOI: 10.1109/5.30749**

**Description**

L'invention concerne un procédé et un système de réflectométrie pour détecter et localiser des défauts non francs dans un câble. Le domaine de l'invention est celui de la réflectométrie temporelle et/ou fréquentielle.

Les systèmes de réflectométrie connus fonctionnent classiquement selon le procédé suivant. Un signal maitrisé, par exemple un signal impulsionnel ou encore un signal multi-porteuses, est injecté à une extrémité du câble à tester. Le signal se propage le long du câble et se réfléchit sur les singularités qu'il comporte.

Une singularité dans un câble correspond à une rupture des conditions de propagation du signal dans ce câble. Elle résulte le plus souvent d'un défaut qui modifie localement l'impédance caractéristique du câble en provoquant une discontinuité dans ses paramètres linéiques.

Le signal réfléchi est rétropropagé jusqu'au point d'injection, puis est analysé par le système de réflectométrie. Le retard entre le signal injecté et le signal réfléchi permet de localiser une singularité, correspondant à un défaut électrique, dans le câble.

L'invention s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie et de mesurer sa réflexion.

Les méthodes de réflectométrie temporelle connues sont particulièrement adaptées à la détection de défauts francs dans un câble, tel un court circuit ou un circuit ouvert ou plus généralement une modification locale significative de l'impédance du câble. La détection du défaut se fait par la mesure de l'amplitude du signal réfléchi sur ce défaut qui est d'autant plus importante et donc détectable, que le défaut est franc.

A l'inverse, un défaut non franc, par exemple résultant d'une dégradation superficielle de la gaine du câble, engendre un pic d'amplitude faible sur le signal de réflectométrie réfléchi et est par conséquent plus difficilement détectable par des méthodes temporelles classiques.

C'est pourquoi des méthodes de réflectométrie temps-fréquence ont été développées afin de permettre une meilleure mise en évidence des signaux réfléchis de faible amplitude. Parmi ces méthodes, on peut citer celle décrite dans le brevet américain US 7337079 qui est basée sur l'application au signal réfléchi dans le câble d'une transformée temps-fréquence de Wigner Ville. Cette méthode permet une meilleure discrimination des réflexions de signal sur des défauts non francs avec une bonne résolution temporelle et fréquentielle.

Cependant cette transformée appartient à la classe des transformées de Cohen et présente un caractère quadratique, ce qui signifie que son application à un signal multi-composantes aboutit à la génération de termes supplémentaires non-souhaités appelés par la suite termes croisés.

De tels termes apparaissent sur le réfléctogramme final comme des pics d'amplitudes pouvant être confondus avec de réels défauts du câble ce qui peut entrainer un phénomène de fausse détection. En outre, ces termes croisés peuvent également masquer l'existence de réels défauts en se superposant aux pics d'amplitude associés aux singularités du câble.

Il existe donc un problème technique qui consiste à supprimer l'influence des termes croisés résultant de l'application d'une transformée de Wigner Ville au signal réfléchi dans le câble.

On connait l'article « The use of the pseudo Wigner Ville Transform for detecting soft defects in electric cables, Maud Franchet et al » qui présente une adaptation de la transformée de Wigner Ville utilisant un fenêtrage de la transformée originale afin de limiter l'influence des termes croisés. Cependant, cette méthode ne permet pas de supprimer complètement l'apparition de pics d'amplitude non désirés.

On connait également l'article « Nonexistence of cross-term free time-frequency distribution with concentration of Wigner-Ville distribution, Zou Hongxing et al » qui traite du problème de l'apparition des termes croisés mais vise à démontrer l'impossibilité d'adapter la transformée de Wigner-Ville pour supprimer totalement les termes croisés.

La présente invention vise ainsi à proposer un procédé et un système de réflectométrie temps-fréquence, utilisant la transformée de Wigner Ville et qui permet de supprimer l'influence des termes croisés afin de garantir une détection correcte des défauts d'un câble sous test, en particulier des défauts non francs.

L'invention a ainsi pour objet un procédé de réflectométrie pour la détection d'au moins un défaut dans un câble comprenant une étape d'acquisition d'un signal S(t) injecté dans ledit câble et réfléchi sur au moins une singularité dudit câble, caractérisé en ce qu'il comprend en outre les étapes suivantes :

- Décomposer ledit signal S(t) réfléchi en une pluralité de composantes temporelles $s_i(t)$,

- Construire, à partir desdites composantes temporelles, une pluralité de signaux intermédiaires $(X_{iq}(t), X_i(t))$ à l'aide de la relation suivante $X_{i(q)}(t) = \alpha.s_i.\delta(t - t_i) + \sum_{j=1, j\neq i}^{n} s_j.\delta(t - t_j)$, pour i variant de 1 au nombre n d'échantillons du signal S(t), avec $\alpha$ un coefficient de pondération égal au nombre complexe j dont le carré est égal à -1 ou égal à une racine nième de l'unité $z_q = e^{j\frac{2q\pi}{n}}$, avec q variant de 1 à la partie entière de n/2,

- Calculer la transformée de Wigner-Ville, $W_{X_i}$, $W_S$, de chacun desdits signaux intermédiaires et dudit signal réfléchi,
- Calculer une transformée temps-fréquence $T_s(t,\omega)$ égale à la somme des transformées de Wigner-Ville desdites composantes temporelles $s_i(t)$, à partir d'une combinaison linéaire desdites transformées de Wigner-Ville de chacun desdits signaux intermédiaires $W_{X_i}$ et dudit signal réfléchi $W_S$, Détecter et localiser les maxima de ladite transformée temps-fréquence $T_s(t,\omega)$, et en déduire l'existence et la localisation des défauts recherchés.

Selon un aspect particulier de l'invention, lorsque ledit coefficient de pondération $\alpha$ est égal à une racine nième de l'unité, la transformée temps-fréquence $T_s(t,\omega)$ est donnée par la relation

$$T_s(t,\omega) = \frac{1}{2.(P+1)}\left\{\sum_{q=1}^{P}\sum_{i=1}^{n}W_{X_{iq}} - [P.(n-2)-2].W_s\right\} \quad \text{si n est pair et par la relation}$$

$$T_s(t,\omega) = \frac{1}{2.P+1}\left\{\sum_{q=1}^{P}\sum_{i=1}^{n}W_{X_{iq}} - [P.(n-2)-1].W_s\right\} \quad \text{si n est impair, avec P un nombre entier égal à la partie entière de}$$

n/2, $W_{X_{iq}}$ la transformée de Wigner Ville du signal intermédiaire $X_{iq}(t)$ et $W_S$ la transformée de Wigner Ville du signal S(t) réfléchi.

Selon un autre aspect particulier de l'invention, lorsque ledit coefficient de pondération $\alpha$ est égal au nombre complexe j dont le carré est égal à -1, la transformée temps-fréquence $T_s(t,\omega)$ est donnée par la relation

$$T_s(t,\omega) = \frac{1}{n-1}\left\{\sum_{i=1}^{n}W_{X_i} - (n-2).W_s\right\}, \quad \text{avec n un entier strictement supérieur à deux, } W_{X_i} \text{ la transformée de Wigner}$$

Ville du signal intermédiaire $X_i(t)$ et $W_S$ la transformée de Wigner Ville du signal S(t) réfléchi.

La décomposition du signal S(t) en une pluralité de composantes temporelles $s_i(t)$ peut être effectuée par sous-échantillonnage.

Elle peut aussi être effectuée par décomposition du signal en une combinaison linéaire de fonctions Gaussiennes.

Elle peut aussi être effectuée à l'aide de la relation suivante : $s(t) = \sum_{i=1}^{N} w(t-t_i).s(t)$, où w est une fenêtre temporelle de longueur donnée appliquée audit signal s(t) à une pluralité d'instants $t_i$ temporels successifs.

Dans une variante de réalisation, le procédé selon l'invention comprend en outre une étape de calcul de la fonction d'intercorrélation temps-fréquence normalisée appliquée au résultat de la transformée temps-fréquence $T_s(t,\omega)$.

Dans une variante de réalisation de l'invention, ledit signal S(t) réfléchi est préalablement débruité après son acquisition.

L'invention a également pour objet un dispositif de traitement d'un signal de réflectométrie comportant des moyens d'acquisition d'un signal réfléchi sur au moins une singularité d'un câble et des moyens de traitement et d'analyse adaptés à mettre en oeuvre le procédé de réflectométrie selon l'invention.

L'invention a encore pour objet un système de réflectométrie comprenant des moyens d'injection d'un signal S(t) dans un câble à tester, des moyens d'acquisition dudit signal réfléchi sur au moins une singularité dudit câble, des moyens de conversion analogique-numérique dudit signal réfléchi, caractérisé en ce qu'il comprend en outre des moyens de traitement et d'analyse adaptés à mettre en oeuvre le procédé de réflectométrie selon l'invention.

D'autres caractéristiques et avantages de l'invention apparaîtront à l'aide de la description qui suit faite en regard de dessins annexés qui représentent :

- La figure 1, un synoptique illustrant un système de réflectométrie selon l'invention pour la détection de défauts non francs dans un câble,
- la figure 2, un diagramme d'un réflectogramme temporel obtenu pour un câble présentant un défaut non franc,
- la figure 3, un diagramme de la transformée de Wigner Ville obtenue après application au réflectogramme temporel de la figure 2,
- la figure 4, un diagramme de la fonction d'intercorrélation temps-fréquence normalisée (ITFN) de la transformée de Wigner Ville appliquée au signal de la figure 2 illustrant les résultats comparatifs obtenus avec deux méthodes de l'art antérieur et la méthode selon l'invention.

La transformée de Wigner Ville fait partie de la classe des transformées de Cohen. Elle est définie par la relation suivante, pour un signal x(t) :

$$W_x(t,\omega) = \frac{1}{2\pi}\int_{-\infty}^{+\infty}\overline{x(t-\frac{\tau}{2})}.x(t+\frac{\tau}{2}).e^{-j\tau\omega}d\tau$$

Où $\overline{x}(t)$ désigne le conjugué du signal x(t) et $\omega$ la pulsation du signal x(t).

A partir de la transformée de Wigner-Ville précédemment définie, il est possible de dériver la transformée de Wigner-Ville "croisée", ou "cross Wigner distribution" en anglais, de deux signaux $x_1$(t) et $x_2$(t) :

$$W_{x_1x_2}(t,\omega) = \frac{1}{2\pi}\int_{-\infty}^{+\infty}\overline{x_1(t-\frac{\tau}{2})}.x_2(t+\frac{\tau}{2}).e^{-j\tau\omega}d\tau$$

L'un des problèmes majeurs de cette transformée vient de son caractère quadratique. En effet, si un signal se présente sous la forme d'une somme de n composantes, la transformée de Wigner Ville laissera apparaître non pas n termes mais n(n-1)/2 + n termes. Pour illustrer ceci, considérons le signal s(t) à deux composantes tel que défini à la relation (1). La transformée de Wigner Ville de s(t) est donnée par l'équation (2). Le terme croisé est égal à $2\mathrm{Re}(W_{s_1s_2}(t,\omega))$

$$s(t) = s_1(t) + s_2(t) \qquad (1)$$

$$W_s(t,\omega) = W_{s_1}(t,\omega) + W_{s_2}(t,\omega) + 2\,\mathrm{Re}(W_{s_1s_2}(t,\omega)) \qquad (2)$$

Un des objectifs de l'invention est de proposer une transformée temps-fréquence adaptée qui ne présente plus de termes croisés.

Pour illustrer l'approche retenue pour aboutir à l'invention, on décrit à présent deux exemples de construction d'une transformée de Wigner Ville adaptée pour un signal s(t) comportant respectivement deux ou trois composantes. Ces deux exemples sont donnés à titre illustratif et pour une meilleure compréhension de l'invention. Comme expliqué plus en avant de la description, l'invention s'applique préférentiellement à un signal composé d'un grand nombre n de composantes pouvant, par exemple, être prises égales chacune à un échantillon du signal numérisé.

Exemple pour un signal à deux composantes.

Considérons tout d'abord le cas où le signal s(t) comporte deux composantes : s(t) = $s_1$(t) + $s_2$(t).
Pour éliminer le terme croisé identifié à la relation (2), il convient de construire une transformée temps fréquence T(t,$\omega$) qui appliquée au signal s donne comme résultat la somme des transformées de Wigner Ville des composantes $s_1$,$s_2$ respectives, soit $T_s(t,\omega) = W_{s_1}(t,\omega) + W_{s_2}(t,\omega)$. $\omega$ désigne la pulsation du signal en radians par seconde qui est directement liée à la fréquence f du signal par la relation connue $\omega = 2\pi$f.

Or l'application de la transformée de Wigner Ville au signal s aboutit à la relation suivante: $W_s(t,\omega) = W_{s_1}(t,\omega) + W_{s_2}(t,\omega) + W_{s_1s_2}(t,\omega) + W_{s_2s_1}(t,\omega)$.

On définit alors deux signaux $x(t)=s_1(t)-s_2(t)$ et $y(t)= -s_1(t)+s_2(t)$. On multiplie ensuite chacun de ces signaux par son conjugué (cf. équations (3) et (4)).

$$x(t).\overline{x}(t) = s_1(t).\overline{s_1}(t) + s_2(t).\overline{s_2}(t) - (s_1(t)\overline{s_2}(t) + s_2(t)\overline{s_1}(t)) \qquad (3)$$

$$y(t).\overline{y}(t) = s_1(t).\overline{s_1}(t) + s_2(t).\overline{s_2}(t) - (s_1(t)\overline{s_2}(t) + s_2(t)\overline{s_1}(t)) \qquad (4)$$

On en déduit alors les transformées de Wigner Ville des deux signaux x(t) et y(t) (cf. équations(5) et (6)).

$$W_x(t,\omega) = W_{s_1}(t,\omega) + W_{s_2}(t,\omega) - (W_{s_1s_2}(t,\omega) + W_{s_2s_1}(t,\omega)) \qquad (5)$$

$$W_y(t,\omega) = W_{s_1}(t,\omega) + W_{s_2}(t,\omega) - (W_{s_1 s_2}(t,\omega) + W_{s_2 s_1}(t,\omega)) \qquad (6)$$

On obtient alors le résultat souhaité en sommant les relations (5),(6) et l'expression de la transformée de Wigner Ville du signal s(t) (cf. équations (7)).

$$T_s(t,\omega) = W_{s_1}(t,\omega) + W_{s_2}(t,\omega)$$
$$= \frac{1}{4}(W_x(t,\omega) + W_y(t,\omega) + 2W_s(t,\omega)) \qquad (7)$$

Pour un signal à deux composantes, la transformée de Wigner-Ville adaptée selon l'invention est ainsi égale à $T_s = \frac{1}{4}(W_x(t,\omega) + W_y(t,\omega) + 2W_s(t,\omega))$. En appliquant cette transformée au signal s, le résultat obtenu est la somme des transformées de Wigner-Ville de chaque composante. Le terme croisé a été supprimé.

Exemple pour un signal à trois composantes.

Passons maintenant au cas d'un signal à trois composantes : s(t) = s$_1$(t) + s$_2$(t) + s$_3$(t).
Pour éliminer tous les termes croisés, il faut construire une transformée de Wigner Ville adaptée T$_s$ de sorte à obtenir le résultat suivant : $T_s(t,\omega) = W_{s_1}(t,\omega) + W_{s_2}(t,\omega) + W_{s_3}(t,\omega)$
Pour ce faire, on définit alors trois signaux qui sont des combinaisons linéaires des trois composantes du signal s, avec $z = e^{2j\frac{\pi}{3}}$ la racine complexe 3$^{\text{ième}}$ de l'unité, c'est-à-dire que le cube de z est égal à 1 :

$$x(t) = z.s_1(t) + s_2(t) + s_3(t)$$

$$y(t) = s_1(t) + z.s_2(t) + s_3(t)$$

$$w(t) = s_1(t) + s_2(t) + z.s_3(t)$$

On calcule alors le produit de ces trois signaux x,y et w avec leurs conjugués respectifs (cf. équations 8,9,10)

$$x(t).\overline{x}(t) = |z|^2 s_1(t).\overline{s_1}(t) + s_2(t).\overline{s_2}(t) + s_3(t).\overline{s_3}(t)$$
$$+ z.(s_1(t).\overline{s_2}(t) + s_1(t).\overline{s_3}(t)) + \overline{z}.(s_2(t).\overline{s_1}(t) + s_3(t).\overline{s_1}(t)) \qquad (8)$$
$$+ s_2(t).\overline{s_3}(t) + s_3(t).\overline{s_2}(t)$$

$$y(t).\overline{y}(t) = s_1(t).\overline{s_1}(t) + |z|^2 s_2(t).\overline{s_2}(t) + s_3(t).\overline{s_3}(t)$$
$$+ z.(s_2(t).\overline{s_1}(t) + s_2(t).\overline{s_3}(t)) + \overline{z}.(s_1(t).\overline{s_2}(t) + s_3(t).\overline{s_2}(t)) \qquad (9)$$
$$+ s_1(t).\overline{s_3}(t) + s_3(t).\overline{s_1}(t)$$

$$w(t).\overline{w}(t) = s_1(t).\overline{s_1}(t) + s_2(t).\overline{s_2}(t) + |z|^2.s_3(t).\overline{s_3}(t)$$
$$+ z.(s_3(t).\overline{s_1}(t) + s_3(t).\overline{s_2}(t)) + \overline{z}.(s_1(t).\overline{s_3}(t) + s_2(t).\overline{s_3}(t)) \qquad (10)$$
$$+ s_1(t).\overline{s_2}(t) + s_2(t).\overline{s_1}(t)$$

On en déduit leurs transformées de Wigner Ville, sachant que |z|$^2$=1 (cf. équations 11, 12 et 13).

$$W_x(t,\omega) = W_{s_1}(t,\omega) + W_{s_2}(t,\omega) + W_{s_3}(t,\omega)$$
$$+ z.(W_{s_1 s_2}(t,\omega) + W_{s_1 s_3}(t,\omega)) + \overline{z}.(W_{s_2 s_1}(t,\omega) + W_{s_3 s_1}(t,\omega)) \qquad (11)$$
$$+ W_{s_2 s_3}(t,\omega) + W_{s_3 s_2}(t,\omega)$$

$$W_y(t,\omega) = W_{s_1}(t,\omega) + W_{s_2}(t,\omega) + W_{s_3}(t,\omega)$$
$$+ z.(W_{s_2 s_1}(t,\omega) + W_{s_2 s_3}(t,\omega)) + \overline{z}.(W_{s_1 s_2}(t,\omega) + W_{s_3 s_2}(t,\omega)) \quad (12)$$
$$+ W_{s_1 s_3}(t,\omega) + W_{s_3 s_1}(t,\omega)$$

$$W_w(t,\omega) = W_{s_1}(t,\omega) + W_{s_2}(t,\omega) + W_{s_3}(t,\omega)$$
$$+ z.(W_{s_2 s_1}(t,\omega) + W_{s_2 s_3}(t,\omega)) + \overline{z}.(W_{s_1 s_2}(t,\omega) + W_{s_3 s_2}(t,\omega)) \quad (13)$$
$$+ W_{s_1 s_3}(t,\omega) + W_{s_3 s_1}(t,\omega)$$

L'étape suivante consiste à sommer les transformées des trois signaux x,y,w (cf. équation 14).

$$W_x(t,\omega) + W_y(t,\omega) + W_w(t,\omega) = 3.(W_{s_1}(t,\omega) + W_{s_2}(t,\omega) + W_{s_3}(t,\omega))$$
$$+ (1 + z + \overline{z}).(W_{s_1 s_2}(t,\omega) + W_{s_1 s_3}(t,\omega) + W_{s_2 s_1}(t,\omega) + W_{s_3 s_1}(t,\omega) + W_{s_2 s_3}(t,\omega) + W_{s_3 s_2}(t,\omega)) \qquad (14)$$

Or $1 + z + \overline{z} = 0$, on obtient donc la transformée de Wigner Ville adaptée permettant d'obtenir le résultat souhaité :

$$T_s(t,\omega) = W_{s_1}(t,\omega) + W_{s_2}(t,\omega) + W_{s_3}(t,\omega)$$
$$= \frac{1}{3}(W_x(t,\omega) + W_y(t,\omega) + W_w(t,\omega)) \qquad (15)$$

<u>Transformée de Wigner Ville adaptée selon l'invention pour un signal à n composantes.</u>
Les exemples décrits ci-dessus pour un signal à deux ou trois composantes peuvent être généralisés pour un signal à n composantes, n étant un entier supérieur ou égal à 2.
Au préalable un rappel est effectué sur la définition et les propriétés des racines nièmes de l'unité.
Les racines nièmes de l'unité sont les solutions de l'équation $z^n = 1$, avec z un nombre complexe et n un entier strictement positif.

Les solutions de cette équation peuvent s'écrire sous la forme $z = e^{j\frac{2k\pi}{n}}$ pour k variant de 0 à n-1.

Les racines nièmes de l'unité présentent les propriétés suivantes. Si z est solution de l'équation $z^n = 1$ alors son conjugué l'est également. On en déduit que si $z = e^{j\frac{2k\pi}{n}}$ avec k variant de 1 à la partie entière de n/2 est une solution, alors $\overline{z} = e^{j\frac{2(n-k)\pi}{n}}$ l'est également. On définit alors le sous-ensemble $S_p$ de solutions de l'équation. Si n est pair, $S_p$ comporte p=n/2 éléments distincts. Si n est impair, $S_p$ comporte p= (n-1)/2 éléments distincts.

Une autre propriété essentielle des racines nièmes de l'unité est que leur somme est nulle : $\sum_{k=0}^{n-1} e^{j\frac{2k\pi}{n}} = 0$.

Ces propriétés sont utilisées par la suite pour élaborer une transformée temps-fréquence adaptée pour éliminer les termes croisés de la transformée de Wigner Ville.

Considérons le signal s(t) égal à la somme de n composantes $s_j$(t): $s(t) = \sum_{j=1}^{n} s_j(t)$. La transformée temps-fréquence adaptée selon l'invention doit vérifier la relation suivante $T_s(t,\omega) = \sum_{j=1}^{n} W_{s_j}(t,\omega)$ , avec $W_{s_j}(t,\omega)$ la transformée de Wigner Ville du signal $s_j$(t).

Pour construire cette transformée, on considère le sous-ensemble S$_p$, constitué des $p = [\frac{n}{2}]$ racines nièmes de l'unité qui sont égales à $z_q = e^{j\frac{2q\pi}{n}}, q = 1...[\frac{n}{2}]$, où [] désigne l'opérateur partie entière.

A partir de ces p racines et du signal s(t), il est possible de construire n.p signaux intermédiaires notés X$_{iq}$, avec i variant de 1 à n et q variant de 1 à p qui seront utilisés dans le calcul de la transformée temps-fréquence adaptée.

$$X_{iq}(t) = z_q.s(t_i)\delta(t - t_i) + \sum_{j=1, j\neq i}^{n} s(t_j)\delta(t - t_j) \; (16)$$

Lorsque le signal s(t) est numérisé, la relation (16) peut également s'écrire sous la forme suivante :

$X_{iq}(t) = z_q.s_i.\delta(t - t_i) + \sum_{j=1, j\neq i}^{n} s_j.\delta(t - t_j)$, où s$_i$ pour i variant de 1 à n sont les échantillons du signal s(t) numérisé. Le signal s(t) peut alors être considéré comme la somme des n composantes s$_i$.δ(t-t$_i$) pour i variant de 1 à n. δ(t) est la fonction de Dirac temporelle. Les signaux intermédiaires construits sont une combinaison linéaire des composantes

Les calculs suivants sont similaires à ceux déjà décrits pour les exemples de n= 2 ou 3 composantes.

La multiplication de chaque signal intermédiaire par son conjugué aboutit à la relation (17) :

$$\begin{aligned} X_{iq}.\overline{X_{iq}} &= |z_q|^2 + s_i\overline{s_i} + \sum_{j=1, j\neq i}^{n} s_j\overline{s_j} \\ &+ z_q.\sum_{j=1, j\neq i}^{n} s_i\overline{s_j} + \overline{z_q}.\sum_{j=1, j\neq i}^{n} s_j\overline{s_i} \\ &+ \sum_{j=1, j\neq i}^{n}\sum_{k=1, k\neq i, j}^{n} s_j\overline{s_k} \end{aligned} \quad (17)$$

Pour une racine d'indice q donnée, les termes $X_{iq}.\overline{X_{iq}}$ sont sommés, sachant que $|z_q|^2 = 1$, quelque soit la valeur de q et on aboutit à la relation (18):

$$\begin{aligned} \sum_{i=1}^{n} X_{iq}.\overline{X_{iq}} &= n\cdot\sum_{j=1}^{n} s_j\overline{s_j} \\ &+ z_q.\sum_{i,j=1, i\neq j}^{n} s_i\overline{s_j} + \overline{z_q}.\sum_{i,j=1, i\neq j}^{n} s_i\overline{s_j} \quad (18) \\ &+ (n-2)\sum_{i,j=1, i\neq j}^{n} s_i\overline{s_j} \end{aligned}$$

Enfin, la relation (18) est sommée sur l'ensemble des valeurs de q pour aboutir à la relation (19) :

$$\begin{aligned} \sum_{q=1}^{P}(\sum_{i=1}^{n} X_{iq}.\overline{X_{iq}}) &= n.P.\sum_{j=1}^{n} s_j\overline{s_j} \\ &+ (\sum_{q=1}^{P}(z_q + \overline{z_q} + n - 2)).(\sum_{i,j=1, i\neq j}^{n} s_j\overline{s_j}) \end{aligned} \quad (19)$$

Il convient ensuite de distinguer les cas où n est pair ou impair. En effet, si n est impair, il n'existe aucune racine z$_q$ appartenant à l'ensemble S$_p$ des racines nièmes de l'unité qui soit égale à son conjugué. Ainsi, la relation suivante peut être établie : $1 + \sum_{q=1}^{P}(z_q + \overline{z_q}) = 0$ et la relation (19) se simplifie pour aboutir à la relation (20) :

$$\sum_{q=1}^{P}(\sum_{i=1}^{n} X_{iq}.\overline{X_{iq}}) = n.P.\sum_{j=1}^{n} s_j \overline{s_j} + (P.(n-2)-1).( \sum_{i,j=1,i\neq j}^{n} s_j \overline{s_j}) \quad (20)$$

Au contraire, si n est pair, il existe une valeur de q pour laquelle $z_q$ est égale à son conjugué et à -1. Dans ce cas $1+\sum_{q=1}^{P}(z_q + \overline{z_q})-1 = 0$ et l'équation (19) se simplifie pour aboutir à la relation (21) :

$$\sum_{q=1}^{P}(\sum_{i=1}^{n} X_{iq}.\overline{X_{iq}}) = n.P.\sum_{j=1}^{n} s_j \overline{s_j} + (P.(n-2)-2).( \sum_{i,j=1,i\neq j}^{n} s_j \overline{s_j}) \quad (21)$$

Enfin, sachant que $s(t).\overline{s(t)} = \sum_{j=1}^{n} s_j \overline{s_j} + \sum_{j=1,i\neq j}^{n} s_j \overline{s_j}$ , on en déduit l'expression de la transformée temps-fréquence adaptée selon l'invention, dans le cas où n est pair (relation (22)) et n est impair (relation (23)) :

$$T_s(t,\omega) = \sum_{j=1}^{n} W_{s_j}(t,\omega) = \frac{1}{2.(P+1)}\left\{\sum_{q=1}^{P}\sum_{i=1}^{n} W_{X_{iq}} -[P.(n-2)-2].W_s\right\} \quad (22)$$

$$T_s(t,\omega) = \sum_{j=1}^{n} W_{s_j}(t,\omega) = \frac{1}{2P+1}\left\{\sum_{q=1}^{P}\sum_{i=1}^{n} W_{X_{iq}} -[P.(n-2)-1].W_s\right\} \quad (23)$$

<u>Application de la transformée temps-fréquence adaptée à la détection de défauts non francs dans un câble.</u>

On décrit à présent les étapes successives de mise en oeuvre du procédé de réflectométrie selon l'invention pour détecter un ou plusieurs défauts non francs dans un câble.

Dans un premier temps, un signal de réfléctométrie est injecté dans le câble à diagnostiquer. Ce signal se réfléchit sur les singularités du câble jusqu'à un point d'acquisition. Le procédé selon l'invention est appliqué à ce signal s(t) réfléchi qui est un signal multi-composantes dès lors qu'au moins un défaut existe sur le câble à tester. Cependant, le nombre et les positions temporelles des composantes ne sont pas connues. Après acquisition sur une durée donnée, le signal s(t) est numérisé pour produire un nombre n d'échantillons $s_i$. Le signal s(t) peut être vu comme la somme de n composantes correspondant aux n échantillons : $s(t) = \sum_{i=1}^{n} s(t_i)\delta(t-t_i) = \sum_{i=1}^{n} s_i.\delta(t-t_i)$ . En fonction de la parité de n, on calcule ensuite la transformée temps-fréquence adaptée $T_s(t,\omega)$ à l'aide de la relation (22) ou (23). Ce calcul passe au préalable par la construction des n.p signaux intermédiaires $X_{iq}$ à partir de la relation (16) puis des transformées de Wigner Ville de chacun de ces signaux intermédiaires ainsi que celle du signal s(t). Le résultat obtenu après application de la transformée $T_s(t,\omega)$ selon l'invention permet ensuite de détecter et de localiser les composantes du signal s(t) qui correspondent à des réflexions sur des singularités du câble sous test. Avantageusement, il est possible d'appliquer à ce résultat une fonction d'intercorrélation temps-fréquence normalisée afin d'améliorer encore la discrimination des défauts. En utilisant la transformée adaptée $T_s(t,\omega)$ en lieu et place d'une transformée de Wigner Ville classique, les termes croisés sont supprimés ce qui permet d'améliorer la fiabilité de la détection et de la localisation des défauts du câble produisant des réflexions de faibles amplitudes.

On décrit à présent une seconde variante de réalisation de l'invention qui présente l'avantage de réduire le nombre de calculs à exécuter pour construire la transformée temps-fréquence adaptée selon l'invention.

Comme mentionné ci-dessus, le calcul de $T_s(t,\omega)$ nécessite un calcul intermédiaire d'un nombre égal à p.n + 1 de transformées de Wigner Ville. Dans une seconde variante, l'invention permet de limiter ce nombre à n +1.

Pour cela, la forme et le nombre de signaux intermédiaires $X_{iq}$ sont modifiés. On construit à présent, toujours à partir des échantillons $s_i$ du signal réfléchi dans le câble à tester, un nombre n de signaux intermédiaires $X_i$, avec i variant de 1 à n tels que $X_i(t) = j.s_i.\delta(t-t_i) + \sum_{k=1,k\neq i}^{n} s_k.\delta(t-t_k)$, avec j le nombre complexe tel que $j^2=-1$.

En multipliant chaque signal $X_i$ par son conjugué on obtient la relation (24) :

$$X_i.\overline{X_i} = \sum_{k=1}^{n} s_k.\overline{s_k} + j.\sum_{k=1,k\neq i}^{n}(s_i\overline{s_k} - s_k\overline{s_i}) + \sum_{k=1,k\neq i}^{n}\sum_{q=1,q\neq i,k}^{n} s_k\overline{s_q} \qquad (24)$$

En sommant tous ces termes on obtient la relation (25) :

$$\sum_{i=1}^{n} X_i.\overline{X_i} = n.\sum_{k=1}^{n} s_k.\overline{s_k} + j.\sum_{i=1}^{n}\sum_{k=1,k\neq i}^{n}(s_i\overline{s_k} - s_k\overline{s_i}) + (n-2).\sum_{i=1}^{n}\sum_{k=1,i\neq k}^{n} s_i\overline{s_k}$$
$$= n.\sum_{k=1}^{n} s_k.\overline{s_k} + (n-2)\sum_{i=1}^{n}\sum_{k=1,i\neq k}^{n} s_i\overline{s_k} \qquad (25)$$

Enfin, on obtient l'expression de la transformée temps-fréquence adaptée, valable pour n > 2:

$$T_s(t,\omega) = \sum_{j=1}^{n} W_{s_j}(t,\omega) = \frac{1}{n-1}\left\{\sum_{i=1}^{n} W_{X_i} - (n-2).W_s\right\} \quad (26)$$

A titre d'exemple illustratif, lorsque n = 2, pour un signal s(t) présentant deux composantes $s_1$ et $s_2$, les signaux intermédiaires sont $x_1 = j.s_1 + s_2$ et $X_2 = s_1 + j.s_2$. En calculant les transformées de Wigner Ville de chacun de ces deux signaux on arrive aux relations suivantes :

$$W_{x_1}(t,\omega) = W_{s_1}(t,\omega) + W_{s_2}(t,\omega) + j.(W_{s_1 s_2}(t,\omega) - W_{s_2 s_1}(t,\omega))$$

$$W_{x_2}(t,\omega) = W_{s_1}(t,\omega) + W_{s_2}(t,\omega) - j.(W_{s_1 s_2}(t,\omega) - W_{s_2 s_1}(t,\omega))$$

La transformée adaptée $T_s(t,\omega) = \frac{1}{2}(W_{x_1}(t,\omega) + W_{x_2}(t,\omega)) = W_{s_1}(t,\omega) + W_{s_2}(t,\omega)$ permet de supprimer les termes croisés inhérents à la transformée de Wigner Ville.

Dans les deux variantes de réalisation de l'invention, la transformée temps-fréquence adaptée $T_s(t,\omega)$ est prise égale à une combinaison linéaire des transformées de Wigner-Ville des signaux intermédiaires $X_i$ ou $X_{iq}$ et du signal S et est construite de sorte à ce qu'elle soit en outre égale à la somme des transformées de Wigner-Ville des composantes $S_j$ du signal S.

Dans les deux variantes de réalisation de l'invention, les signaux intermédiaires peuvent être exprimés sous la forme $X_{i(q)}(t) = \alpha.s_i.\delta(t - t_i) + \sum_{j=1,j\neq i}^{n} s_j.\delta(t - t_j)$ pour i variant de 1 au nombre n d'échantillons du signal S(t), avec $\alpha$ un coefficient de pondération égal au nombre complexe j dont le carré est égal à -1 ou égal à une racine nième de l'unité, selon le mode de réalisation choisi.

Dans une autre variante de réalisation de l'invention, le signal rétropropagé et numérisé est au préalable débruité, par exemple en lui appliquant une méthode de débruitage par ondelettes ou toute autre méthode connue permettant d'améliorer le rapport signal à bruit.

Dans une autre variante de réalisation de l'invention, le signal numérisé est sous-échantillonné de sorte à ne conserver qu'une partie des échantillons disponibles pour la construction des signaux intermédiaires. Ainsi, le nombre de calculs à mettre en oeuvre est limité, cependant cette variante présente l'inconvénient d'une moins bonne discrimination temporelle des défauts.

Dans une autre variante de réalisation de l'invention, le signal s(t) peut être décomposé de façon différente que par l'intermédiaire d'une simple numérisation. En effet de façon plus générale, tout signal s(t) peut être décomposé sous la forme d'une série convergente de fonctions Gaussiennes :

$s(t) = \sum_{i=1}^{N} \alpha_i.g_i(t)$ , avec N un entier suffisamment grand pour assurer une convergence correcte de la suite, $\alpha_i$ des coefficients réels et $g_i(t)$ un ensemble de fonctions Gaussiennes. Dans ce cas, le procédé selon l'invention s'applique à l'identique en remplaçant dans la définition des signaux intermédiaires $X_i, X_{iq}$, les échantillons $s_i$ du signal numérisé

par les composantes $\alpha_i.g_i(t)$.

Le signal s(t) peut également être décomposé à l'aide d'une fenêtre temporelle w(t) de longueur temporelle T, centrée en 0 et telle que $\int_{-\infty}^{+\infty}|w(t)|^2 = 1$. Le signal s(t) est alors décomposé de la façon suivante : $s(t) = \sum_{i=1}^{N} w(t - t_i).s(t)$. Autrement dit, les composantes du signal s(t) sont, dans ce cas, égales à la pondération du signal lui-même par la fenêtre w(t) centrée aux instants $t_i$.

On décrit à présent la mise en oeuvre du procédé selon l'invention dans un système de réfléctométrie ainsi que les résultats obtenus à l'aide de l'invention sur l'amélioration de la détection de défauts non francs dans un câble.

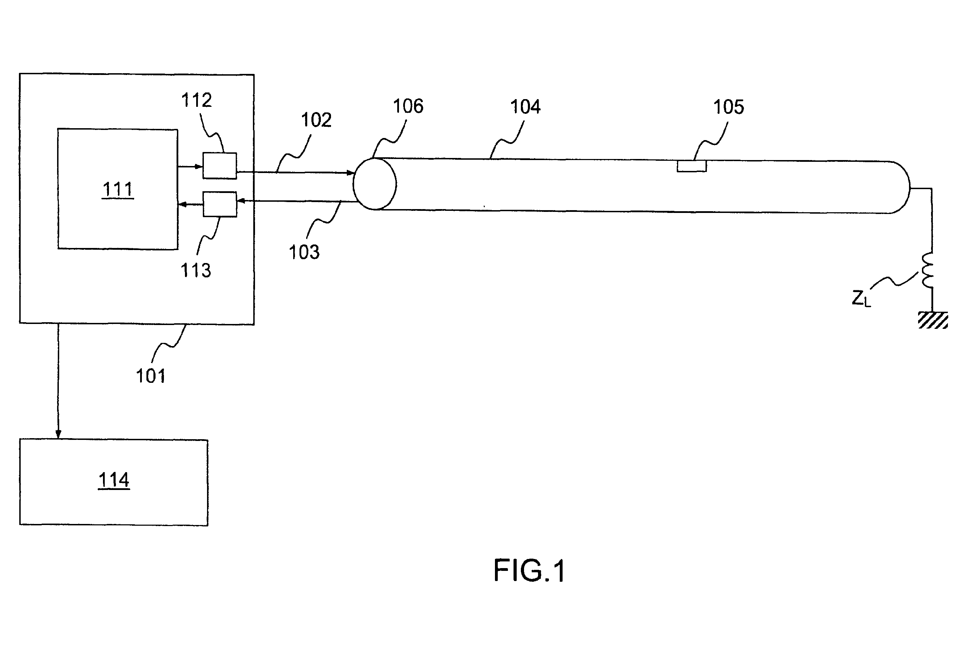

La figure 1 décrit un synoptique d'un exemple de système de réflectométrie selon l'invention.

Un câble à tester 104 présente un défaut non franc 105 à une distance quelconque d'une extrémité quelconque 106 du câble.

Le système de réfléctométrie 101 selon l'invention comprend un composant électronique 111 de type circuit intégré, tel un circuit à logique programmable, par exemple de type FPGA, ou micro-contrôleur, adapté à exécuter deux fonctions. D'une part, le composant 111 permet de générer un signal de réflectométrie s(t) à injecter dans le câble 104 sous test. Ce signal généré numériquement est ensuite converti via un convertisseur numérique-analogique 112 puis injecté 102 à une extrémité 106 du câble. Le signal s(t) se propage dans le câble et est réfléchi sur la singularité engendrée par le défaut 105. Le signal réfléchi est rétropropagé jusqu'au point d'injection 106 puis capturé 103, converti numériquement via un convertisseur analogique-numérique 113, et transmis au composant 111. Le composant électronique 111 est en outre adapté à exécuter les étapes du procédé selon l'invention décrit ci-dessus afin de produire, à partir du signal s(t) reçu, un réflectogramme temps-fréquence qui peut être transmis à une unité de traitement 114, de type ordinateur, assistant numérique personnel ou autre pour afficher les résultats des mesures sur une interface homme-machine.

Le système 101 décrit à la figure 1 est un exemple de réalisation nullement limitatif. En particulier les deux fonctions exécutées par le composant 111 peuvent être séparées dans deux composants ou dispositifs distincts, par exemple un premier dispositif de génération et d'injection du signal de réflectométrie dans le câble 104 à tester et un second dispositif d'acquisition et de traitement du signal réfléchi. Dans un tel cas de figure, le procédé selon l'invention est mis en oeuvre dans le second dispositif d'acquisition et de traitement du signal réfléchi.

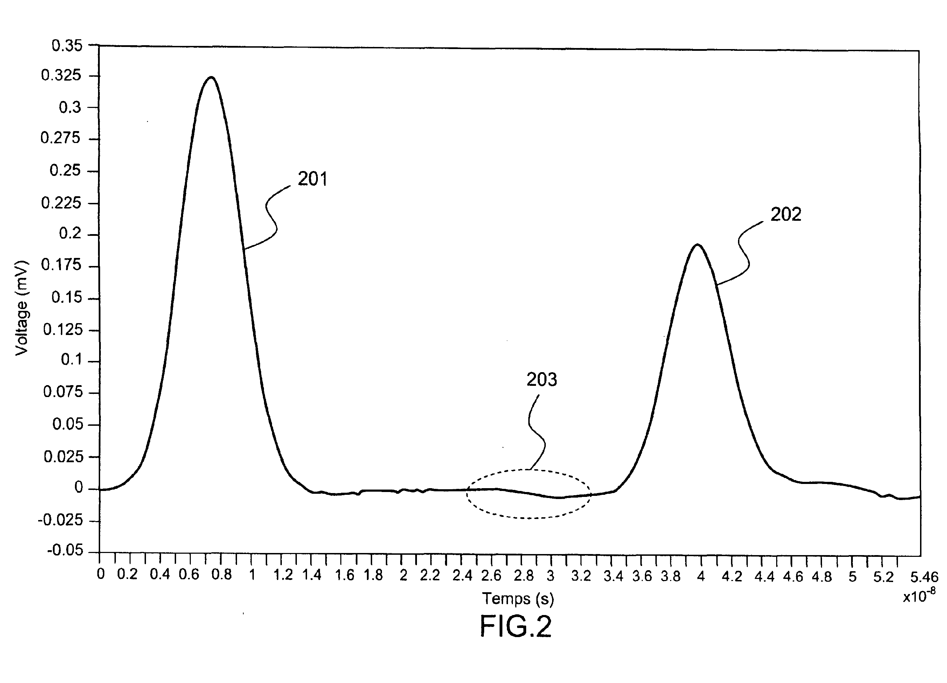

La figure 2 représente, sur un diagramme temps-tension, l'amplitude du signal s(t) rétropropagé lorsque le signal de réflectométrie injecté est une simple impulsion Gaussienne et sans la mise en oeuvre de l'invention.

Ce signal est multi-composantes puisqu'il résulte de la somme de l'impulsion réfléchie sur la désadaptation d'entrée 201, sur la fin du câble 202 et sur le défaut non franc 203. On remarque que l'amplitude 203 du signal réfléchi sur le défaut non franc est faible et donc difficilement détectable.

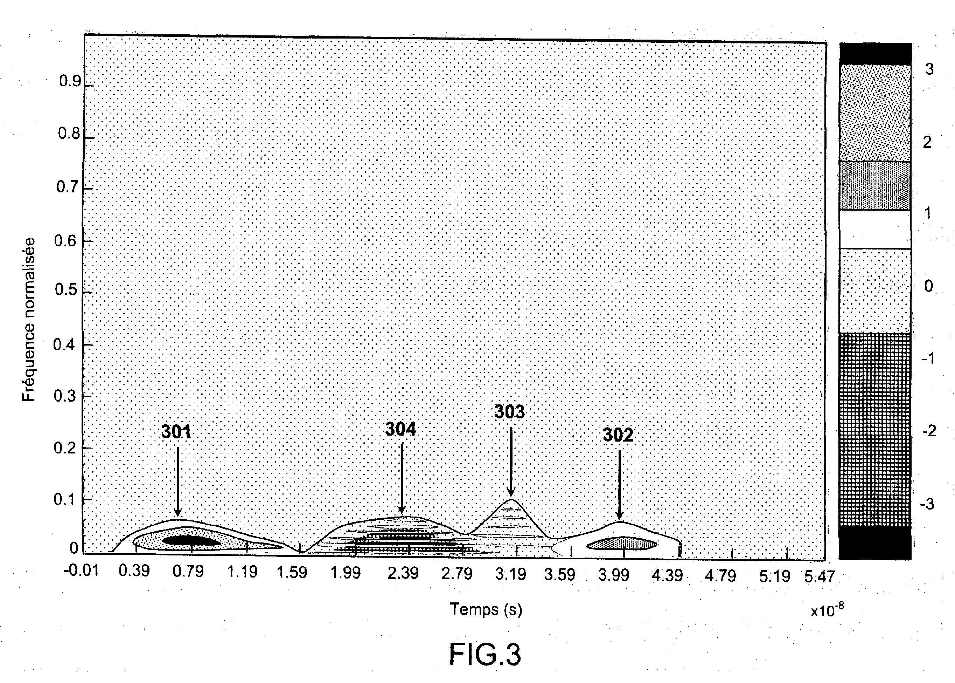

La figure 3 illustre, sur un diagramme temps-fréquence, le résultat obtenu après application de la transformée de Wigner Ville classique au signal représenté temporellement à la figure 2. On retrouve les deux pics fréquentiels correspondant à la désadaptation d'entrée du câble 301 et à la réflexion du signal sur l'extrémité du câble 302. L'amplitude du pic 303 relatif à la réflexion sur le défaut non franc est par contre masquée par l'apparition d'un pic parasite 304 résultant du terme croisé induit par le caractère quadratique de la transformée de Wigner Ville. Ce terme croisé est dû à l'interaction entre l'impulsion réfléchie sur la fin du câble et celle réfléchie sur la désadaptation d'entrée.

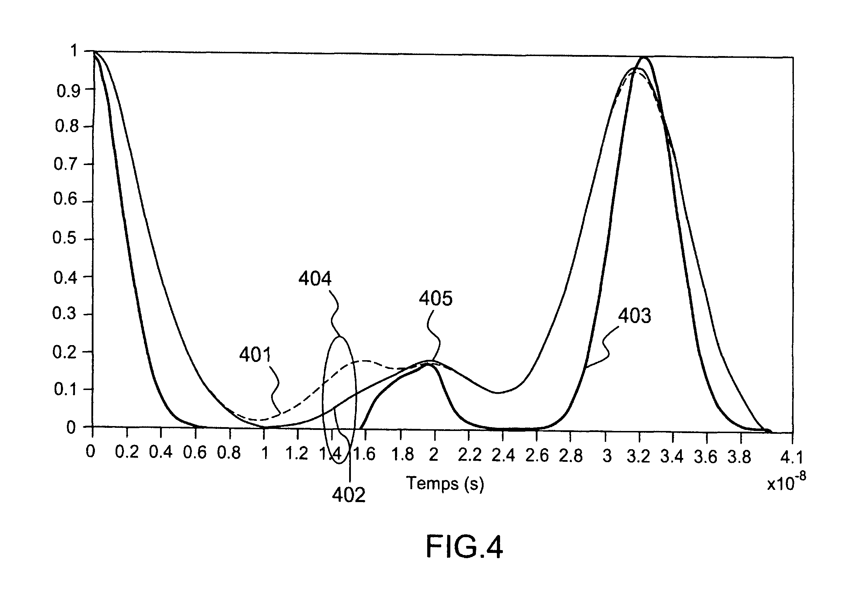

La figure 4 représente, sur un diagramme temporel, le résultat de l'application d'une fonction d'intercorrélation temps-fréquence normalisée au signal temps-fréquence de la figure 3. Ce résultat 401 montre toujours l'existence d'un pic 404 parasite de même amplitude que le pic 405 associé au défaut non franc. Sur la figure 3 est également représenté le même résultat 402 lorsqu'une transformée de Wigner Ville adaptée selon l'art antérieur décrit dans «The use of the pseudo Wigner Ville Transform for detecting soft defects in electric cables, Maud Franchet et al » est utilisée en remplacement de la transformée de Wigner Ville classique. Dans ce cas, l'amplitude du pic 404 associé au terme croisé est diminuée mais n'est pas supprimée. Enfin, un troisième résultat 403 est représenté sur le même diagramme de la figure 4. Il correspond à l'application de la transformée temps-fréquence selon l'invention. On remarque que l'influence du terme croisé est cette fois totalement supprimée. Le pic d'amplitude 405 associé au défaut non franc peut être détecté sans ambiguïté et avec une précision de localisation accrue, la largeur de l'impulsion réfléchie étant moindre que pour les solutions de l'art antérieur comme l'illustre également la courbe 403 de la figure 4.

L'invention a également pour avantage de permettre une meilleure localisation des termes utiles car ces derniers ne sont pas pollués par la présence de termes interférents. Le risque de fausse détection est supprimé.

**Revendications**

**1.** Procédé de réflectométrie pour la détection d'au moins un défaut (105) dans un câble (104) comprenant une étape d'acquisition d'un signal S(t) injecté dans ledit câble (104) et réfléchi sur au moins une singularité dudit câble (104), **caractérisé en ce qu'**il comprend en outre les étapes suivantes :

• Décomposer ledit signal S(t) réfléchi en une pluralité de composantes temporelles $s_i(t)$,

• Construire, à partir desdites composantes temporelles, une pluralité de signaux intermédiaires $(X_{iq}(t), X_i(t))$ à l'aide de la relation suivante $X_{i(q)}(t) = \alpha.s_i.\delta(t - t_i) + \sum_{j=1, j \neq i}^{n} s_j.\delta(t - t_j)$ , pour i variant de 1 au nombre n d'échantillons du signal S(t), avec $\alpha$ un coefficient de pondération égal au nombre complexe j dont le carré est égal à -1 ou égal à une racine nième de l'unité $z_q = e^{j\frac{2q\pi}{n}}$ , avec q variant de 1 à la partie entière de n/2,

• Calculer la transformée de Wigner-Ville, $W_{xi}$, $W_s$, de chacun desdits signaux intermédiaires et dudit signal réfléchi,

• Calculer une transformée temps-fréquence $T_s(t,\omega)$ égale à la somme des transformées de Wigner-Ville desdites composantes temporelles $s_i(t)$, à partir d'une combinaison linéaire desdites transformées de Wigner-Ville de chacun desdits signaux intermédiaires $W_{xi}$ et dudit signal réfléchi $W_s$, Détecter et localiser les maxima de ladite transformée temps-fréquence $T_s(t,\omega)$, et en déduire l'existence et la localisation des défauts (105) recherchés.

2. Procédé de réflectométrie selon la revendication 1 **caractérisé en ce que**, lorsque ledit coefficient de pondération $\alpha$ est égal à une racine nième de l'unité, la transformée temps-fréquence $T_s(t,\omega)$ est donnée par la relation

$$T_s(t,\omega) = \frac{1}{2.(P+1)} \left\{ \sum_{q=1}^{P} \sum_{i=1}^{n} W_{X_{iq}} - [P.(n-2) - 2].W_s \right\} \quad \text{si n est pair et par la relation}$$

$$T_s(t,\omega) = \frac{1}{2.P+1} \left\{ \sum_{q=1}^{P} \sum_{i=1}^{n} W_{X_{iq}} - [P.(n-2) - 1].W_s \right\} \text{ si n est impair, avec P un nombre entier égal à la partie entière}$$

de n/2, $W_{Xiq}$ la transformée de Wigner Ville du signal intermédiaire $X_{iq}(t)$ et $W_s$ la transformée de Wigner Ville du signal S(t) réfléchi.

3. Procédé de réflectométrie selon la revendication 1 **caractérisé en ce que**, lorsque ledit coefficient de pondération $\alpha$ est égal au nombre complexe j dont le carré est égal à -1, la transformée temps-fréquence $T_s(t,\omega)$ est donnée par la relation $T_s(t,\omega) = \frac{1}{n-1} \left\{ \sum_{i=1}^{n} W_{X_i} - (n-2).W_s \right\}$ , avec n un entier strictement supérieur à deux, $W_{Xi}$ la transformée de Wigner Ville du signal intermédiaire $X_i(t)$ et $W_S$ la transformée de Wigner Ville du signal S(t) réfléchi.

4. Procédé de réflectométrie selon l'une des revendications précédentes dans lequel la décomposition du signal S(t) en une pluralité de composantes temporelles $s_i(t)$ est effectuée par sous-échantillonnage.

5. Procédé de réflectométrie selon l'une des revendications 1 à 3 dans lequel la décomposition du signal S(t) en une pluralité de composantes temporelles $s_i(t)$ est effectuée par décomposition dudit signal en une combinaison linéaire de fonctions Gaussiennes.

6. Procédé de réflectométrie selon l'une des revendications 1 à 3 dans lequel la décomposition du signal S(t) en une pluralité de composantes temporelles $s_i(t)$ est effectuée à l'aide de la relation suivante : $s(t) = \sum_{i=1}^{N} w(t - t_i).s(t)$ , où w est une fenêtre temporelle de longueur donnée appliquée audit signal s(t) à une pluralité d'instants $t_i$ temporels successifs.

7. Procédé de réflectométrie selon l'une des revendications précédentes **caractérisé en ce qu'**il comprend en outre une étape de calcul de la fonction d'intercorrélation temps-fréquence normalisée appliquée au résultat de la transformée temps-fréquence $T_s(t,\omega)$.

8. Procédé de réflectométrie selon l'une des revendications précédentes **caractérisé en ce que** ledit signal S(t) réfléchi est préalablement débruité après son acquisition.

9. Dispositif de traitement d'un signal de réflectométrie comportant des moyens d'acquisition (103) d'un signal réfléchi sur au moins une singularité (105) d'un câble (104) et des moyens de traitement et d'analyse (111) adaptés à mettre en oeuvre le procédé de réflectométrie selon l'une des revendications précédentes.

10. Système de réflectométrie comprenant des moyens d'injection (102) d'un signal S(t) dans un câble (104) à tester, des moyens d'acquisition (103) dudit signal réfléchi sur au moins une singularité (105) dudit câble (104), des moyens de conversion analogique-numérique (113) dudit signal réfléchi, **caractérisé en ce qu'**il comprend en outre des moyens de traitement et d'analyse (111) adaptés à mettre en oeuvre le procédé de réflectométrie selon l'une des revendications 1 à 8.

**Patentansprüche**

1. Reflektometrieverfahren zur Erkennung mindestens eines Fehlers (105) in einem Kabel (104), das einen Empfangsschritt eines in das Kabel (104) eingespeisten und auf mindestens einer Unregelmäßigkeit des Kabels (104) reflektieren Signals S(t) umfasst, **dadurch gekennzeichnet, dass** es ferner die folgenden Schritte umfasst:

   • Zerlegen des reflektierten Signals S(t) in eine Vielzahl zeitlicher Komponenten $s_i(t)$,
   • Konstruieren, aus den zeitlichen Komponenten, einer Vielzahl von Übergangssignalen $(X_{iq},(t), X_i(t))$ mit Hilfe

   der folgenden Gleichung $X_{i(q)}(t) = \alpha.s_i.\delta(t - t_i) + \sum_{j=1, j \neq i}^{n} s_j.\delta(t - t_j)$, wobei i zwischen 1 und der Anzahl n von Proben des Signals S(t) schwankt, wobei $\alpha$ ein Wichtungskoeffizient gleich der komplexen Zahl j ist, deren Quadrat gleich -1 oder gleich einer n-ten Wurzel der Einheit $z_q = e^{j\frac{2q\pi}{n}}$ ist, wobei q zwischen 1 und dem ganzzahligen Teil von n/2 um 1 schwankt,
   • Berechnen der Wigner-Ville-Transformation $W_{Xi}$, $W_s$ jedes der Übergangssignale und des reflektierten Signals,
   • Berechnen einer Zeit-Frequenz-Transformation $T_s(t,\omega)$ gleich der Summe der Wigner-Ville-Transformationen der zeitlichen Komponenten $s_i(t)$, aus einer linearen Kombination der Wigner-Ville-Transformationen jedes der Übergangssignale $W_{Xi}$ und des reflektierten Signals $W_s$, Erkennen und Lokalisieren der Maxima der Zeit-Frequenz-Transformation $T_s(t,\omega)$ und Ableiten daraus des Vorhandenseins und der Lokalisierung der gesuchten Fehler (105).

2. Reflektometrieverfahren nach Anspruch 1, **dadurch gekennzeichnet, dass**, wenn der Wichtungskoeffizient $\alpha$ gleich der n-ten Wurzel der Einheit ist, die Zeit-Frequenz-Transformation $T_3(t,\omega)$ durch die Gleichung

   $$T_s(t,\omega) = \frac{1}{2.(P+1)}\left\{\sum_{q=1}^{P}\sum_{i=1}^{n} W_{X_{iq}} - [P.(n-2)-2].W_s\right\}$$ ausgedrückt wird, wenn n gerade ist, und durch die Gleichung

   $$T_s(t,\omega) = \frac{1}{2.P+1}\left\{\sum_{q=1}^{P}\sum_{i=1}^{n} W_{X_{iq}} - [P.(n-2)-1].W_s\right\}$$ wenn n ungerade ist, wobei P eine Ganzzahl gleich dem ganzzahligen Teil von n/2, $W_{Xiq}$ die Wigner-Ville-Transformation des Übergangssignals $X_{iq}(t)$ und $W_s$ die Wigner-Ville-Transformation des reflektierten Signals S(t) ist.

3. Reflektometrieverfahren nach Anspruch 1, **dadurch gekennzeichnet, dass**, wenn der Wichtungskoeffizient a gleich der komplexen Zahl j ist, deren Quadrat gleich -1 ist, die Zeit-Frequenz-Transformation $T_s(t,\omega)$ durch die Gleichung

   $$T_s(t,\omega) = \frac{1}{n-1}\left\{\sum_{i=1}^{n} W_{X_i} - (n-2).W_s\right\}$$ gegeben ist, wobei n eine Ganzzahl strikt größer als zwei, $W_{Xi}$ die Wigner-Ville-Transformation des Übergangssignals $X_i(t)$ und $W_s$ die Wigner-Ville-Transfornation des reflektierten Signals S(t) ist.

4. Reflektometrieverfahren nach einem der vorangehenden Ansprüche, wobei das Zerlegen des Signals S(t) in eine Vielzahl zeitlicher Komponenten $s_i(t)$ durch Unterstichprobe durchgeführt wird.

5. Reflektometrieverfahren nach einem der Ansprüche 1 bis 3, wobei das Zerlegen des Signals S(t) in eine Vielzahl

zeitlicher Komponenten $s_i(t)$ durch Zerlegen des Signals in eine lineare Kombination Gausscher Funktionen durchgeführt wird.

6. Reflektometrieverfahren nach einem der Ansprüche 1 bis 3, wobei das Zerlegen des Signals S(t) in eine Vielzahl zeitlicher Komponenten $s_i(t)$ mit Hilfe der folgenden Gleichung $s(t) = \sum_{i=1}^{N} w(t - t_i).s(t)$ durchgeführt wird, wobei w ein Zeitfenster gegebener Länge, angewendet auf das Signal s(t) während einer Vielzahl zeitlich aufeinanderfolgender Momente $t_i$, ist.

7. Reflektometrieverfahren nach einem der vorangehenden Ansprüche, **dadurch gekennzeichnet, dass** es ferner einen Berechnungsschritt der genormten Zeit-Frequenz-Interkorrelationsfunktion, angewendet auf das Ergebnis der Zeit-Frequenz-Transformation $T_s(t,\omega)$, umfasst.

8. Reflektometrieverfahren nach einem der vorangehenden Ansprüche, **dadurch gekennzeichnet, dass** das reflektierte Signal S(t) nach seinem Empfang zunächst entstört wird.

9. Vorrichtung zur Verarbeitung eines Reflektometriesignals, die Empfangsmittel (103) für ein auf mindestens einer Unregelmäßigkeit (105) eines Kabels (104) reflektiertes Signal und Verarbeitungs- und Analysemittel (111) aufweist, die ausgebildet sind, um das Reflektometrieverfahren nach einem der vorangehenden Ansprüche umzusetzen.

10. Reflektromettiesystem, das Einspeisemittel (102) für ein Signal S(t) in ein zu testendes Kabel (104), Empfangsmittel (103) für das auf mindestens einer Unregelmäßigkeit (105) des Kabels (104) reflektierte Signal, Analog-Digital-Umwandlungsmittel (113) für das reflektierte Signal umfasst, **dadurch gekennzeichnet, dass** es ferner Verarbeitungs- und Analysemittel (111) umfasst, die ausgebildet sind, um das Reflektometrieverfahren nach einem der Ansprüche 1 bis 8 umzusetzen.

## Claims

1. A reflectometry method for detecting at least one fault (105) in a cable (104), comprising a step of acquiting a signal S(t) injected into said cable (104) and reflected on at least one singular section of said cable (104), **characterised in that** it further comprises the following steps:

   • dividing said reflected signal S(t) into a plurality of time components $s_i(t)$;
   • constructing, on the basis of said time components, a plurality of intermediate signals ($X_{iq}(t)$, $X_i(t)$) using the following relation $X_{i(q)}(t) = \alpha.s_i.\delta(t - t_i) + \sum_{j=1, j \neq i}^{n} s_j.\delta(t - t_j)$ , where i varies from 1 to n number of samples of the signal S(t), with $\alpha$ being $\alpha$ weighting coefficient equal to the complex number j, the square of which is equal to -1 or equal to an nth root of the unit $z_q = e^{j\frac{2q\pi}{n}}$ , with q varying from 1 to the integer part of n/2;
   • computing the Wigner-Ville transform, $W_{Xi}$, $W_S$, of each of said intermediate signals and of said reflected signal;
   • computing a time-frequency transform $T_s(t, \omega)$ equal to the sum of the Wigner-Ville transforms of said time components $s_i(t)$ on the basis of a linear combination of said Wigner-Ville transforms of each of said intermediate signals $W_{Xi}$ and of said reflected signal $W_s$; detecting and locating the maximums of said time-frequency transform $T_s(t, \omega)$ and deducing therefrom the existence and the location of the faults (105) to be found.

2. The reflectometry method according to claim 1, **characterised in that**, when said weighting coefficient $\alpha$ is equal to an nth root of the unit, said time-frequency transform $T_s(t, \omega)$ is provided by the relation

$$T_s(t,\omega) = \frac{1}{2.(P+1)} \left\{ \sum_{q=1}^{P} \sum_{i=1}^{n} W_{X_{iq}} - [P.(n-2)-2].W_s \right\} \quad \text{if n is even and by the relation}$$

$$T_s(t,\omega) = \frac{1}{2.P+1} \left\{ \sum_{q=1}^{P} \sum_{i=1}^{n} W_{X_{iq}} - [P.(n-2)-1].W_s \right\} \quad \text{if n is odd, with P being an integer number equal to the}$$

integer part of n/2, $W_{Xiq}$ being the Wigner-Ville transform of the intermediate signal $X_{iq}(t)$ and $W_s$ being the Wigner-Ville transform of the reflected signal S(t).

3. The reflectometry method according to claim 1, **characterised in that**, when said weighting coefficient $\alpha$ is equal to the complex number j, the square of which is equal to -1, said time-frequency transform $T_s(t, \omega)$ is provided by

the relation $T_s(t, \omega) = \dfrac{1}{n-1} \left\{ \sum_{i=1}^{n} W_{X_i} - (n-2).W_s \right\}$ with n being an integer strictly greater than two, $W_{Xi}$ being the Wigner-Ville transform of the intermediate signal $X_i(t)$ and $W_S$ being the Wigner-Ville transform of the reflected signal S(t).

4. The reflectometry method according to any one of the preceding claims, wherein the signal S(t) is divided into a plurality of time components $s_i(t)$ by sub-sampling.

5. The reflectometry method according to any one of claims 1 to 3, wherein the signal S(t) is divided into a plurality of time components $s_i(t)$ by dividing said signal into a linear combination of Gaussian functions.

6. The reflectometry method according to any one of claims 1 to 3, wherein the signal S(t) is divided into a plurality of time components $s_i(t)$ using the following relation: $s(t) = \sum_{i=1}^{N} w(t - t_i).s(t)$ where w is a time window with a given length applied to said signal s(t) at a plurality of successive time instants $t_i$.

7. The reflectometry method according to any one of the preceding claims, **characterised in that** it further comprises a step of computing the normalised time-frequency intercorrelation function applied to the result of said time-frequency transform $T_s(t, \omega)$.

8. The reflectometry method according to any one of the preceding claims, **characterised in that** noise is previously removed from said reflected signal S(t) after it is acquired.

9. A device for processing a reflectometry signal, comprising means (103) for acquiring a reflected signal on at least one singular section (105) of a cable (104) and processing and analysis means (111) adapted to implement the reflectometry method according to any one of the preceding claims.

10. A reflectometry system, comprising means (102) for injecting a signal S(t) into a cable (104) to be tested, means (103) for acquiting said reflected signal on at least one singular section (105) of said cable (104), means (113) for the analogue-digital conversion of said reflected signal, **characterised in that** it further comprises processing and analysis means (111) adapted to implement the reflectometry method according to any one of claims 1 to 8.

FIG.1

FIG.2

FIG.3

EP 2 769 230 B1

FIG.4

EP 2 769 230 B1

**EP 2 769 230 B1**

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7337079 B